**Europäisches Patentamt**

**European Patent Office**

**Office européen des brevets**

(19)

(11) Veröffentlichungsnummer : **0 515 353 A2**

(12) # EUROPÄISCHE PATENTANMELDUNG

(21) Anmeldenummer : **92890121.4**

(22) Anmeldetag : **20.05.92**

(51) Int. Cl.$^5$ : **G01R 31/36**

(30) Priorität : **24.05.91 AT 1061/91**

(43) Veröffentlichungstag der Anmeldung :
**25.11.92 Patentblatt 92/48**

(84) Benannte Vertragsstaaten :
**CH DE ES FR GB IT LI**

(71) Anmelder : **S.E.A. Studiengesellschaft für
Energiespeicher und Antriebssysteme
Gesellschaft m.b.H.
Bleckmanngasse 10 Postfach 49
A-8680 Mürzzuschlag (AT)**

(72) Erfinder : **Tomazic, Gerd, Dipl.-Ing. Dr.
Hofkirchergasse 4
A-8680 Mürzzuschlag (AT)**

(74) Vertreter : **Widtmann, Georg, Dr.
S.E.A. Studiengesellschaft für
Energiespeicher und Antriebssysteme
Gesellschaft m.b.H. Postfach 49
Bleckmanngasse 10
A-8680 Mürzzuschlag (AT)**

(54) **Verfahren zur Bestimmung des Ladezustandes einer Zink-Brom-Batterie sowie Verfahren zum Laden derselben.**

(57) Verfahren zur Bestimmung des Ladezustandes einer wiederaufladbaren Zink-Brom-Batterie mit mehreren in Serie geschaltenen bipolaren Elektroden, umlaufenden wäßrigen Elektrolyten, wobei die oxidierten Bromionen mit einem im Elektrolyten gelösten Komplexbildner einen im Elektrolyten im wesentlichen unlöslichen Komplex bilden und Zink an der Elektrode abgeschieden wird und zwischen den Elektrodenräumen jeweils ein Diaphragma angeordnet ist, wobei die elektrische Spannung einer oder mehrerer in Serie geschalteter Zellen, insbesondere bei einer vorbestimmten Stromentnahme pro vorbestimmter Zeiteinheit, bestimmt und ausgewertet, insbesondere angezeigt, wird.

Fig.2

EP 0 515 353 A2

Die Erfindung bezieht sich auf ein Verfahren zur Bestimmung des Ladezustandes einer Zink-Brom-Batterie mit mehreren in Serie geschalteten bipolaren Elektroden und mit umlaufenden wäßrigen Elektrolyten sowie auf ein Verfahren zum Laden derselben.

Bei der Speicherung von Energie ist genauso bestimmend wie die Kapazität des Speichers der Ladezustand desselben. Nur mit einer exakten Ermittlung des Ladezustandes kann auch die gesamte Kapazität eines Speichers genutzt werden.

Bei dem am weitest verbreiteten Speicher für elektrische Energie und zwar die Blei-Schwefelsäure-Batterie wird üblicherweise die Dichte des Elektrolyten gemessen und damit der Ladezustand der Batterie bestimmt. Diese Dichtemessung wird durch Entnahme einer Elektrolyt-Teilmenge aus der Batterie und anschließende Spindelung durchgeführt. Ein derartiges Verfahren ist zur laufenden Kontrolle des Ladezustandes nicht geeignet.

Aus dem Buch Blei- und Stahlakkumulatoren von Erich Witte, 3. Auflage Mainz 1967, S. 61 - 63 wird ein Entladeanzeiger für Bleibatterien bekannt, bei dem eine kombinierte Strom- und Spannungsmessung durchgeführt wird, wobei für die Strommessung ein einstellbarer Nebenwiderstand Verwendung findet. Wie in dieser Literaturstelle angegeben, wird jedoch durch diese kombinierte Strom- und Spannungsmessung die Bestimmung des Spannungswertes im Ruhestand verfälscht und weiters die Kapazitätsbestimmung wesentlich gestört, wenn ca. 50 % des Entladezustandes erreicht ist. Damit ist die Kalibrierung des Zeigerinstrumentes in Prozent des Ladungszustandes lediglich von untergeordnetem Wert, denn die angezeigten Meßdaten weisen eine zu große Unsicherheit auf.

Die Spannung eines galvanischen Elementes ergibt sich aus dem Potential das durch die elektrochemische Spannungsreihe vorgegeben ist. Liegen jedoch innerhalb der Batterie zwei oder mehrere Oxidationsstufen vor, so können Mischpotentiale der verschiedenen Oxidationsstufen auftreten. Bei der Blei-Schwefelsäure-Batterie liegt im geladenen Zustand an der positiven Elektrode Bleisuperoxid und an der negativen Elektrode Blei vor. Als Elektrolyt dient Schwefelsäure. Bei der Entladung werden die vierwertigen Ionen des Bleisuperoxides in zweiwertige Ionen und zwar Bleisulfat übergeführt. Gleichzeitig wird das metallische Blei an der anderen Elektrode ebenfalls in Bleisulfat übergeführt. Die Spannung an der positiven Elektrode hängt nun von der Konzentration der vierwertigen und der zweiwertigen Bleiionen und die an der negativen Elektrode lediglich von der Konzentration der zweiwertigen Bleiionen bei überschüssigem metallischen Blei ab. Die Konzentration der vierwertigen Ionen sinkt mit zunehmender Entladung, wohingegen bezogen auf das zweiwertige Bleiion eine gesättigte Bleisulfatlösung vorliegt. Ist das feste also das an der Elektrode abgeschiedene Bleisuperoxid verbraucht so fällt die Spannung schnell bis zu ganz kleinen Werten ab, d.h. daß in der Endphase beim Entladen der Batterie die Gesamtspannung abfällt. Zur Bestimmung des Ladezustandes der Batterie, insbesondere bei einem höheren Ladungszustand z.B. daß die Batterie zu 80 % oder 90 % geladen ist, kann somit die Spannung nicht als Indikator dienen. Weiters ist zur Einstellung der aktuellen Spannung eine relativ große Zeitspanne erforderlich, sodaß die Spannungsmessung keine Realwerte für die Kapazität der Batterie ergibt.

Aus der DE-B2-2,028.117 wird eine Vorrichtung zum Steuern eines Ladegerätes offensichtlich für einen Bleiakkumulator bekannt, bei der während des Ladens die aktuelle Akkumulatorspannung in einem Analogspeicher gespeichert wird. Nach einem vorbestimmten Zeitintervall, beispielsweise einer Zehntelsekunde wird sodann die aktuelle Akkumulatorspannung mit dem zuvor gemessenen Wert verglichen. Liegt keine Spannungszunahme vor, so wird die Verbindung zum Ladegerät unterbrochen. Um die Akkumulatorspannung zu messen muß damit die Ladestromspannung geringer als die aktuelle Spannung des Akkumulators sein, damit der gemessene Spannungswert nicht dem der Ladestromquelle entspricht.

Aus der EP A1 149.498 wird eine Zink-Brom-Batterie mit umlaufenden Elektrolyten bekannt. Die elektrochemischen Vorgänge beim Entladen sind derart, daß einerseits metallisches Zink von der Elektrode als zweiwertiges Zinkbromid in Lösung geht und anderseits molekulares Brom in Bromidionen übergeführt wird. Die Konzentration des Zinks bzw. des Broms ist konstant, da einerseits metallisches Zink an der Elektrode vorliegt und anderseits Brom lediglich aufgrund des Gleichgewichts zwischen einem Bromkomplex und dem wäßrigen Elektrolyten die Konzentration vorgegeben ist. Auch liegen sowohl beim Zink lediglich zwei Formen und zwar das nullwertige und zweiwertige Zink als auch beim Brom das nullwertige und einwertige Bromion vor. Der Bromkomplex ist schwer wasserlöslich, wohingegen der Komplexbildner als solcher im wäßrigen Elektrolyten gelöst wird. Die Menge des schwer wasserlöslichen Bromkomplexes ist somit eine direkte Maßzahl des Ladezustandes einer Zink-Brom-Batterie oben angeführter Bauart. Da der Bromkomplex eine höhere Dichte als Wasser aufweist, scheidet sich derselbe am Boden eines Elektrolytbehälters ab. Durch Bestimmung der Füllstandshöhe kann der Ladezustand der Batterie ermittelt werden. Zu erheblichen Fehlern kommt es hiebei, wenn die Temperatur des Elektrolyten nicht berücksichtigt wird, da aufgrund der Volumszunahme mit erhöhter Temperatur bzw. Abnahme mit niedrigerer Temperatur eine zusätzliche Größe zur Berücksichtigung kommen muß. Ein weiterer Störfaktor, der zwar nicht bei stationären aber bei mobilen Batterien, wie er beispielsweise in Kraftfahrzeugen vorliegen kann, besteht darin, daß bei der Füllstandsmessung der Elektrolytbehälter waagerecht angeordnet sein soll. Liegt diese Anordnung nicht vor, so kann je nach Neigung des Elektrolytbehälters und Anordnung des Schwimmers, der zur Füllstandsmessung dient, ein zu geringer bzw. zu hoher Ladezustand angezeigt werden. Auch ist die Genauigkeit einer derartigen Anzeige von der Konfiguration des Elektrolytbehälters abhängig. Je geringer die Grundfläche und je höher der Elektrolytbehälter ist desto genauer ist die Anzeige. Bei Batterien für den mobilen Einsatz besteht jedoch das Erfordernis die Batterien und damit auch die Elektrolytbehälter möglichst flach auszuführen, sodaß derartige Füllstandsmessungen mit großer Ungenauigkeit behaftet sind.

Die Erfindung hat sich zum Ziel gesetzt, ein Verfahren zur Bestimmung des Ladezustandes von wiederaufladbaren Zink-Brom-Batterien zu schaffen, das unabhängig von der geometrischen Ausgestaltung des Elektrolyt-Reservoirs ist und keine mechanische Vorrichtungen wie Spindel, Schwimmer oder dgl. bedingt.

Das erfindungsgemäße Verfahren zur Bestimmung des Ladezustandes einer wiederaufladbaren Zink-Brom-Batterie mit mehreren in Serie geschalteten bipolaren Elektroden mit umlaufenden wäßrigen Elektrolyten, wobei die oxidierten Bromionen mit einem im wäßrigen Elektrolyten gelösten Komplexbildner einen im Elektrolyten im wesentlichen schwer wasserlöslichen Komplex bilden und Zink an der Elektrode abgeschieden wird und zwischen den Elektrodenräumen jeweils ein Diaphragma angeordnet ist, besteht im wesentlichen darin, daß die elektrische Spannung einer oder mehrerer in Serie geschalteter Zellen, insbesondere bei einer vorbestimmten Stromentnahme pro vorbestimmter Zeiteinheit, bestimmt und ausgewertet, insbesondere angezeigt, wird.

Bei einer Zink-Brom-Batterie mit umlaufenden Elektrolyten und einem Komplexbildner für das molekulare Brom ist während des gesamten Lade- und Entladevorganges die Aktivität sowohl des Zinks als auch des Broms konstant. Der innere Widerstand der Batterie, insbesondere die Leitfähigkeit des Elektrolyten, ändert sich mit der Zinkionen-Konzentration. Je mehr die Batterie entladen wird umso mehr metallisches Zink wird von der Elektrode gelöst und umsomehr Brom wird zu Bromionen reduziert, sodaß die Konzentration der Zink- und Bromionen im Elektrolyten steigt. Konstant hingegen bleibt die Konzentration der Zusätze im Elektrolyten wie beispielsweise Leitsalze, die lediglich zugegeben werden um die Leitfähigkeit des Elektrolyten zu erhöhen. Weiters ist der Elektrolyt durch eine Emulsion gebildet, welche mit dem wäßrigen Elektrolyten und den im wesentlichen im Wasser unlöslichen Bromkomplex gebildet ist. Der schwer wasserlösliche Bromkomplex bedeckt nun einen Teil der Elektrode und auch des Diaphragmas, sodaß der wirksame Querschnitt für den Stromdurchgang verringert wird, wodurch der elektrische Widerstand der Zelle erhöht wird. Trotz der einander überlagernden Effekte steigt die Spannung der Batterie mit zunehmender Ladung und sinkt mit abnehmendem Ladungszustand.

Wird unmittelbar vor der Spannungsmessung ermittelt ob Strom den Zellen zugeführt oder entnommen wurde, so kann eine besonders genaue Kapazitätsermittlung durchgeführt werden, da geringere Unterschiede bei einer bestimmten Ladungskapazität in der Spannung der Batterie vorliegen je nachdem ob geladen oder entladen wird.

Wird die elektrische Spannung und/oder ein digitaler Wert derselben mit einem vorermittelten Wert verglichen und die so ermittelte absolute und/oder relative gespeicherte Strommenge der Batterie angezeigt, so kann auf besonders einfache vergleichende Messung die Kapazität festgelegt werden, wobei gleichzeitig den jeweiligen besonderen Eigenschaften der Batterie, des Elektrolyten, der Elektroden, des Diaphragmas und dgl. besonders einfach Rechnung getragen werden kann.

Wird die Bestimmung der Spannung während des Änderns der Stromentnahme bei einer bestimmten Stromleistungsentnahme der Betriebsbelastung durchgeführt, so erfolgt die Kapazitätsbestimmung der Batterie jeweils bei erhöhter bzw. abnehmender Stromentnahme, die wesentliche Änderungen der Kapazität bedingen können, sodaß nicht durch ein Zeitglied die Abstände der Kapazitätsbestimmung festgelegt werden, sondern entsprechend der Belastung der Batterie durchgeführt werden.

Um die Genauigkeit der Kapazitätsbestimmung der Batterie zu erhöhen kann auch die Temperatur des Elektrolyten bestimmt werden, wobei dann zur Ermittlung der Kapazität der Batterie ein Vergleich mit entsprechenden Spannungswerten bei den entsprechenden Temperaturen durchgeführt wird.

Das erfindungsgemäße Verfahren zum Laden einer Zink-Brom-Batterie mit umlaufenden Elektrolyten, in Serie geschalteten durch Diaphragmen getrennte Zellen, bipolaren Elektroden, wobei das oxidierte Brom mit einem im wäßrigen Elektrolyten gelösten Komplexbildner einen im wesentlichen wasserunlöslichen Komplex bildet, besteht im wesentlichen darin, daß die Spannung der Zink-Brom-Batterie während einer Ladepause gemessen und mit einem vorgegebenen Wert verglichen wird und bei Erreichen bzw. Überschreiten desselben die Stromzufuhr unterbrochen wird. Durch diese Vorgangsweise wird eine besonders einfache Vorgangsweise zum Laden geschaffen, wobei gleichzeitig Oberlastungen der Batterie durch Stromzufuhr bei bereits elektrochemisch vollständig geladener Batterie verhindert werden, sodaß keine unerwünschten thermischen Belastungen oder durch Oberspannungen bedingte Zersetzung von Bestandteilen des Elektrolyten bedingt werden.

Eine besonders vorteilhafte Verfahrensweise zur Ladung einer Zink-Brom-Batterie ist dann gegeben, wenn bei Unterschreiten eines bestimmten Spannungswertes mit Ende der Stromentnahme eine Ladestromquelle an die Batterie angeschlossen wird.

Im folgenden wird die Erfindung an Hand der Zeichnungen näher erläutert:

Es zeigen: Fig. 1 ein Blockschaltbild zur Messung der Spannung bei vorgegebenen Belastungen und Fig. 2 ein Blockschaltbild zur Messung der Spannung beim Laden der Batterie. Fig. 3 und Fig. 4 Diagramme, die die Abhängigkeit der Spannung vom Ladezustand zeigen.

Die in den Beispielen eingesetzte Zink-Brom-Batterie weist bipolare Elektroden auf, die mit kunststoffgebundenen Ruß aufgebaut sind. Die äußeren Ränder der Elektrode weisen keinen Kohlenstoff auf und sind daher elektrisch isolierend. Diese äußeren Bereiche sind mit Diaphragmen verbunden, die im Abstand zu leitenden Bereichen der Elektroden angeordnet sind. Es sind eine Vielzahl von Elektroden in Serie geschaltet. Die Anoden- bzw. Kathodenräume werden von einem umlaufenden Elektrolyten in fluidmäßiger Parallelschaltung angeströmt. Die Ableitung der Elektrolyten erfolgt in analoger Weise. An den jeweiligen Enden der Batterie sind elektrische Ableiter vorgesehen um die Stromentnahme bzw. die Ladung derselben zu ermöglichen. Der Elektrolyt, welcher bei der ungeladenen Batterie zum Einsatz kommt, weist folgende Zusammensetzung auf:

3 Mol Zinkbromid und 1 Mol Morpholiniumbromid pro Liter Wasser.

Als Komplexbildner kommen beispielsweise neben Morpholinium auch quarternäre Ammoniumsalze, wie z.B. Pyrrolidiumsalze und dgl. zum Einsatz. Während der Ladung der Batterie wird an der Elektrode ein Zinkfilm bzw. elementares Brom abgeschieden. Das elementare Brom bildet mit dem in der wäßrigen Phase gelösten Komplexbildner eine ölige Phase, die schwerer als der wäßrige Elektrolyt ist und in diesem im wesentlichen nicht löslich ist. Es kommt somit zu einer Suspensionsbildung. Durch den umgepumpten Elektrolyten wird auch der schwerere Komplex aus den Elektrodenräumen gefördert. Gleichzeitig ist beim Laden der Batterie an der Oberfläche der Elektrode eine willkürliche Abscheidung des Bromkomplexes der elektrisch isolierend ist, vorhanden. Der Bromkomplex ist auch teilweise am Diaphragma abgelagert, sodaß der Innenwiderstand der Zelle beim Laden dadurch erhöht wird.

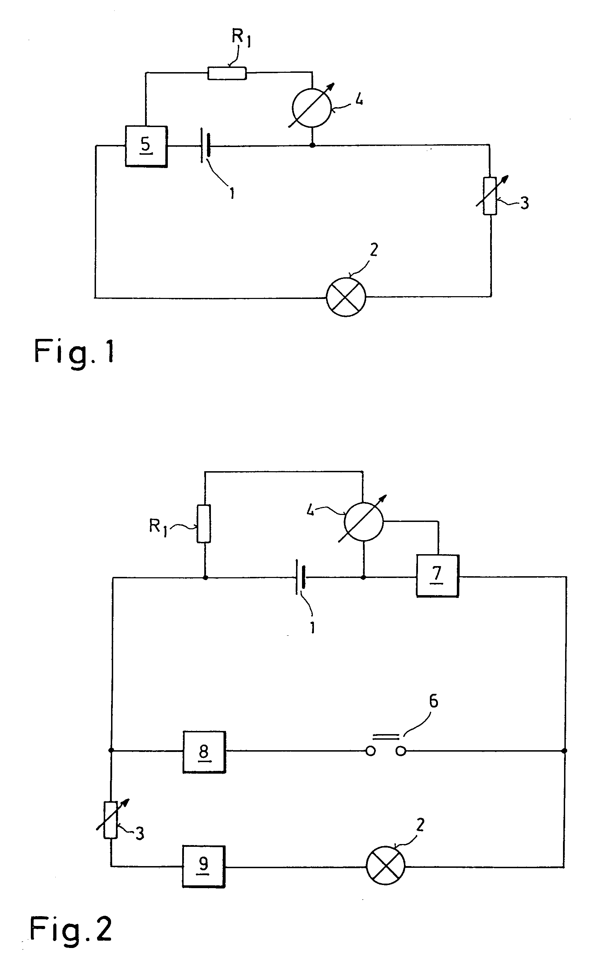

Bei dem in Fig. 1 dargestellten Blockschaltbild ist an die Zink-Brom-Batterie 1 ein Verbraucher 2 geschaltet. Die Stromaufnahme des Verbrauchers wird durch den Leistungsregler 3 geregelt. In Parallelschaltung zum Verbraucher 2 ist ein Voltmeter 4 geschaltet, wobei der Stromkreis zum Voltmeter 4 mit Widerstand R 1 über den Schalter 5 z.B. über ein Zeitglied geöffnet bzw. geschlossen werden kann. Anstelle eines Zeitgliedes kann auch ein Schalter vorgesehen sein, der den Stromkreis zum Voltmeter 4 bei einer vorbestimmten Belastung z.B. auch bei keiner Belastung schließt, sodaß z.B. jeweils bei ändernden Belastungen die Spannung der Batterie und damit die Kapazität derselben bestimmt wird.

Das aus dem Voltmeter ausgehende Signal kann entweder analog oder digital angezeigt werden, wobei beispielsweise bei Analoganzeige anstelle der Spannung die Kapazität der Batterie angezeigt wird. Es besteht allerdings auch die Möglichkeit, daß das aus dem Spannungsmesser ausgehende Signal mit einer ähnlichen Reihe von Vergleichsmessungen verglichen wird und dann die noch verfügbare Kapazität angezeigt wird. Da aufgrund der unterschiedlichen Ionenbeweglichkeit mit der Temperatur eine Abhängigkeit von der Temperatur des Elektrolyten gegeben ist, kann auch die Temperatur des Elektrolyten zusätzlich berücksichtigt werden.

Die Schaltung gemäß Fig. 1 kann beispielsweise beim mobilen Einsatz von Zink-Brom-Batterien wie sie für Elektromobile bevorzugt sind, zum Einsatz kommen.

Bei der in Fig. 2 dargestellten Schaltung ist das Voltmeter 4 zum Verbraucher 2 bzw. Ladestromquelle 6 parallel geschaltet. Über den Schalter 7 wird der Spannungsmesser 4 in einem bestimmten Belastungsbereich der Batterie durch den Verbraucher 2 eingeschaltet. Dieser Belastungsbereich kann sehr nieder z.B. gleich Null sein. Nimmt der Verbraucher 2 keinen Strom auf, so unterbricht der Schalter 9 den Stromkreis zur Batterie 1. Mit Zeitverzögerung wird im Spannungsmeß- und Schaltglied die Spannung der Batterie 1 gemessen und bei Unterschreiten eines vorgegebenen Wertes die Spannungsquelle 6 über den Schalter 8 an die Batterie zum Aufladen derselben angeschlossen. Eine derartige Schaltung kann beispielsweise bei dem mobilen Einsatz von Batterien zum Laden derselben während einer Geschwindigkeitsreduktion des Fahrzeuges also einer sog. Nutzbremsung durchgeführt werden. Eine derartige Schaltung ist jedoch auch für stationäre Batterien sinnvoll, wenn ein bestimmter Ladezustand jeweils gewährleistet sein soll.

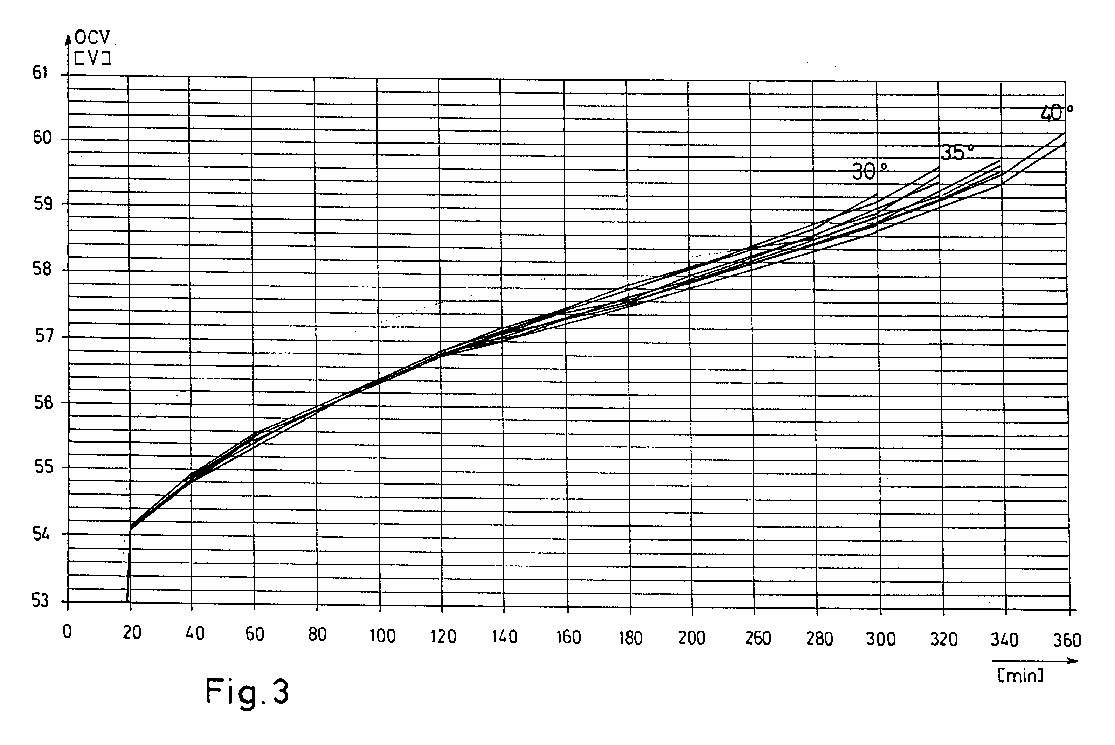

Das in Fig. 3 dargestellte Diagramm gibt das Laden einer Zink-Brom-Batterie mit einem konstanten Strom von 25 A wieder. Bei 30°C ist nach ca. 300 Minuten der Endladezustand erreicht und die Spannung der Batterie gemessen mit einer Belastung von 0,3 A beträgt 59,2 V. Bei einer Elektrolyt-Temperatur von 35°C wird erst nach 320 Minuten bei einem Ladestrom von 25 A der Endladezustand erhalten, wobei hier eine Spannung gemessen bei einem Strom von 0,3 A 59,7 V beträgt. Bei einer Elektrolyt-Temperatur von 40°C wird der vollständige Ladezustand nach ca. 360 Minuten erreicht, wobei die Spannung gemessen bei einem Strom von 0,3 A 60,1 V beträgt. Wie den Spannungszeitkurven zu entnehmen, treten erst ca.

nach der Hälfte der gesamten Ladezeit signifikantere Unterschiede der Spannungen in bezug auf die Elektrolyt-Temperatur auf. Bei einem Elektrolyten mit 35°C und einer Gesamtladezeit von 320 Minuten weist die Batterie nach 80 Minuten, also einer Viertel Ladezeit ca. 55,9 V auf. Wie dem Diagramm in Fig. 3 und auch den obigen Ausführungen zu entnehmen, kann somit aus der Spannung der Batterie während des Ladens ein direkter Rückschluß auf den Ladezustand gezogen werden.

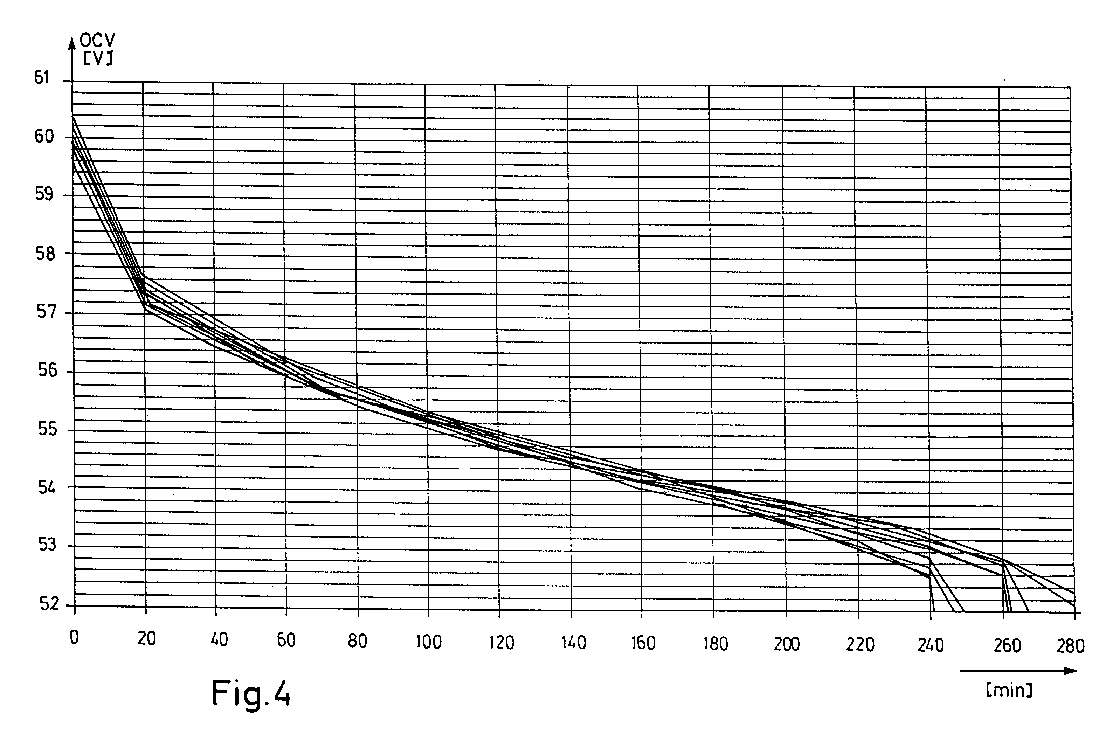

In Fig. 4 ist in Diagrammen der Entladevorgang und zwar das Absinken der Batteriespannung bei 30° C entsprechend der ersten Kurvenschar, die zwischen 240 und 260 Minuten das Potential 52 V erreicht, 35°C entsprechend der Kurven die zwischen 260 und 280 Minuten das 52 V-Potential erreicht und 40° C entsprechend der beiden Kurven die nach 280 Minuten das Potential 52 V erreicht, dargestellt. Die Spannungsabnahmekurven wurden durch Belastung der Batterien bei entsprechender Elektrolyt-Temperatur mit konstanter Entnahme eines Stromes von 25 A erhalten. Wie diesen Kurven besonders deutlich zu entnehmen ist, tritt in den ersten 20 Minuten eine besonders starke Absenkung der Spannung und auch im letzten Kapazitätsbereich eine besonders starke Absenkung der Spannung auf. Je nach Temperatur des Elektrolyten beträgt die Anfangsspannung zwischen 59,6 und 60,4 V. Diese Spannung sinkt nach 20 Minuten auf 57,1 bis 57,7 V ab. Nach der Entnahme von ca. 25 % der Ampere Stunden sinkt die Spannung auf 56,1 bis 55,4 V. Bei Entnahme der Hälfte der zur Verfügung stehenden Ampere-Stunden weist die Batterie eine Spannung von ca. 54,8 V auf und wie dieser Darstellung zu entnehmen tritt erst im letzten Bereich wenn fast bereits die gesamte Energie aus der Batterie entnommen wurde genauso wie im ersten Zeitbereich der Entnahme eine starke Absenkung der Spannung auf.

Durch den im wesentlichen stetigen Verlauf der Kurven mit Ausnahme von einem geringen Anfangund Endbereich sowohl beim Laden als auch Entladen kann über einen großen Bereich der Ladungszustand der Batterie bestimmt werden, wobei die Temperatur nur in den jeweiligen Endbereichen beim Laden und Entladen einen gewissen Unterschied in der Spannung der Batterie bewirkt.

Bei Vergleich der Kurven von Fig. 3 und 4 also der Zunahme der Spannung während des Ladens mit einem Strom von 25 A und der Abnahme der Spannung in der Batterie bei einer Stromentnahme mit 25 A kann man feststellen, daß die Spannung nicht nur davon abhängig ist welcher Ladezustand vorliegt, sondern auch ob die Batterie beladen oder entladen wird, sodaß bei besonders genauen Messungen auch berücksichtigt werden muß, ob eine Ladung oder eine Entladung vorliegt. Um diesen Unterschied in der Abhängigkeit von Spannung zur Kapazität je nach dem ob geladen oder entladen wird zu berücksichtigen kann ein eigenes Glied vorgesehen sein, das den Vergleich der Spannung jeweils entsprechend dem Lade- bzw. Entladezustand vergleicht.

**Patentansprüche**

1. Verfahren zur Bestimmung des Ladezustandes einer wiederaufladbaren Zink-Brom-Batterie mit mehreren in Serie geschalteten bipolaren Elektroden, mit vmlaufenden wäßrigen Elektrolyten, wobei die oxidierten Bromionen mit einem im Elektrolyten gelösten Komplexbildner einen im Elektrolyten im wesentlichen unlöslichen Komplex bilden und Zink an der Elektrode abgeschieden wird und zwischen den Elektrodenräumen jeweils ein Diaphragma angeordnet ist, dadurch gekennzeichnet, daß die elektrische Spannung einer oder mehrerer in Serie geschalteter Zellen, insbesondere bei einer vorbestimmten Stromentnahme pro vorbestimmte Zeiteinheit, bestimmt und ausgewertet, insbesondere angezeigt wird.

2. Verfahren nach Anspruch 1, dadurch gekennzeichnet, daß unmittelbar vor der Spannungsmessung ermittelt wird, ob Strom den Zellen zugeführt oder entnommen wurde.

3. Verfahren nach Anspruch 1 oder 2, dadurch gekennzeichnet, daß die elektrische Spannung und/oder ein digitaler Wert derselben mit vorermittelten Werten verglichen wird und die so ermittelte absolute und/oder relative gespeicherte Strommenge der Batterie angezeigt wird.

4. Verfahren nach Anspruch 1, 2 oder 3, dadurch gekennzeichnet, daß die Bestimmung der Spannung während ändernder Stromentnahme der Betriebsbelastung durchgeführt wird.

5. Verfahren nach einem der Ansprüche 1 bis 4, dadurch gekennzeichnet, daß die Temperatur des/der Elektrolyten bestimmt und bei der Ermittlung der Kapazität der Batterie als variable Größe eingeführt wird.

6. Verfahren zum Laden einer Zink-Brom-Batterie mit umlaufenden Elektrolyten, in Serie geschaltenen durch Diaphragmen getrennten galvanischen Zellen, bipolaren Elektroden, wobei das oxidierte Brom mit einem im wäßrigen Elektrolyten gelösten Komplexbildner einen im wesentlichen wasserunlöslichen Komplex bildet, dadurch gekennzeichnet, daß die Spannung der Zink-Brom-Batterie während einer Ladepause, z.B. bei bestimmter Stromentnahme, gemessen wird und mit einem vorgegebenen Wert verglichen wird und bei Erreichen bzw. Überschreiten eines desselben eine weitere Stromzufuhr zur Batterie unterbrochen wird.

7. Verfahren nach Anspruch 6, dadurch gekennzeichnet, daß bei Unterschreiten eines bestimmten Spannungswertes mit Ende der Stromentnahme eine Ladestromquelle an die Batterie angeschlossen wird.

Fig.1

Fig.2

Fig.3

EP 0 515 353 A2

Fig.4